# FASCICULE DE BREVET EUROPEEN

(11) **EP 0 739 783 B1**
(45) Date de publication et mention de la délivrance du brevet: **16.06.1999**
(21) Numéro de dépôt: 96400884.1
(22) Date de dépôt: 25.04.1996
(51) Int. Cl.: B60R 16/02

(54) **Platine de servitude pour véhicule, notamment automobile**
Zentralelektrik für Kraftfahrzeuge
Electrical distribution center for vehicle

(30) Priorité: 25.04.1995 FR 9504917
(43) Date de publication de la demande: 30.10.1996
(73) Titulaire: VALEO ELECTRONIQUE, 94000 Creteil (FR)
(72) Inventeur: Boucheron, Jean-Louis, 77136 Savigny Le Temple (FR)
(74) Mandataire: Martin, Jean-Jacques

(56) Documents cités:
- EP-A- 0 403 335
- EP-A- 0 547 957
- DE-A- 4 340 280
- DE-C- 3 744 603
- DE-U- 8 909 674
- DE-U- 9 100 962

## Description

La présente invention est relative aux platines de servitude pour véhicules, notamment automobiles.

Classiquement, une platine de servitude regroupe une pluralité de boîtiers électroniques pour la gestion de différents organes du véhicule, ainsi que des composants de puissance, tels que des fusibles de protection, des relais ou analogues, ces différents boîtiers et composants étant reliés entre eux, ainsi qu'aux différentes sources d'alimentation du véhicule (alimentation par la batterie, pour les composants correspondant aux organes nécessitant une alimentation lorsque le contact est coupé - alimentation accessoire pour les composants et boîtiers correspondant aux organes dont l'alimentation est coupée lors de la phase de démarrage - alimentation dite APC ou "après contact" pour les organes nécessaires au roulage et dont l'alimentation ne peut être coupée durant la phase de démarrage).

Il a déjà été proposé des structures de platines de servitude dans lesquelles les différents boîtiers et composants sont regroupés sur un même boîtier.

On pourra à cet égard avantageusement se référer à la demande de brevet française publiée sous FR-A-2 690 601.

Une telle structure reste toutefois d'un montage compliqué et d'une modularité insuffisante.

On pourra également se référer à la demande EP 547 957 dans laquelle il est décrit un boîtier de servitude de véhicule automobile comportant une platine de servitude de puissance et une unité centrale de multiplexage pour la gestion des différents organes fonctionnels du véhicule.

Ce boîtier de servitude est également d'une modularité insuffisante.

Par ailleurs, on connaît en outre par DE-A-43 40 280 une structure de boîtier pour composants électroniques permettant l'empilement de plusieurs modules.

Toutefois, dans ce document DE-A-43 40 280, l'application aux modules de servitude de véhicule automobile n'est aucunement envisagée. En outre, il n'y est fait aucune distinction entre des moyens d'électronique de puissance et des moyens d'électronique de gestion.

L'invention propose quant à elle une platine de servitude de véhicule, notamment automobile, comportant des moyens d'électronique de puissance portés au moins en partie par un substrat plan reçu dans un boîtier, ce boîtier comportant des moyens pour sa connexion électrique à des sources d'alimentation, ainsi qu'à des organes du véhicule commandés par lesdits moyens d'électronique, ladite platine comportant en outre des moyens d'électronique de gestion reçus dans un autre boîtier, les deux boîtiers comportant des moyens de connexion mécaniques et électriques par lesquels ils sont assemblés de façon amovible (platine d'un genre semblable à celle selon FR-A-2 690 601), ladite platine étant caractérisée en ce qu'elle comporte plusieurs boîtiers d'électronique de puissance, les moyens de connexion du boîtier d'électronique de gestion et des boîtiers d'électronique de puissance permettant un assemblage modulable des boîtiers d'électronique de puissance sur le boîtier d'électronique de gestion.

Une telle platine de servitude est d'un montage simplifié, le nombre d'opérations nécessaires pour la réalisation d'un montage étant considérablement diminuées par rapport aux dispositifs de l'art antérieur.

Sa structure permet en outre une grande modularité en fonction du niveau d'équipement requis pour le véhicule.

Cette platine est avantageusement complétée par les différentes caractéristiques suivantes prises seules ou selon leurs combinaisons techniquement possibles :
- chaque boîtier comporte des moyens pour sa connexion électrique à des sources d'alimentation, ainsi qu'à des organes du véhicule commandés par les moyens d'électronique portés par son substrat ;
- lesdits moyens pour la connexion électrique des boîtiers aux sources et aux organes comportent d'une part des broches de connexion s'étendant à partir des substrats portant les moyens d'électronique et traversant les boîtiers perpendiculairement aux plans desdits substrats, ainsi que des broches de connexion de forme en L s'étendant à partir desdits substrats et traversant la tranche des boîtiers ;
- les boîtiers sont portés par un support comportant une partie semelle, sur laquelle est fixé le boîtier d'électronique de gestion, et une tranche qui est perpendiculaire à ladite semelle et qui présente des moyens de connexion femelles destinées à coopérer avec les broches en L des boîtiers ;
- les moyens pour la fixation du boîtier d'électronique de gestion sur la partie semelle du support comporte un téton reçu dans une rainure complémentaire, ainsi que des moyens de verrouillage élastique ;
- le boîtier d'électronique de gestion présente des pattes de verrouillage élastiques pour l'assemblage du ou des boîtiers d'électronique de puissance sur ledit boîtier d'électronique de gestion ;
- un boîtier est constitué par deux demi-boîtiers en plastique moulé assemblés l'un sur l'autre ;
- le boîtier d'électronique de gestion présente deux oreilles latérales opposées pour la fixation de la platine de servitude à l'intérieur de l'habitacle du véhicule ; la partie semelle du support présente deux oreilles latérales opposées pour la fixation de la platine de servitude à l'intérieur de l'habitacle du véhicule.

D'autres caractéristiques et avantages de l'invention ressortiront encore de la description qui suit. Cette description est purement illustrative et non limitative. Elle doit être lue en regard des dessins annexés sur lesquels :
- La Figure 1 est une représentation schématique en coupe d'une platine de servitude conforme à un mode de réalisation possible pour l'invention ;
- La Figure 2 est une représentation schématique en coupe d'un détail d'une platine de servitude conforme à un autre mode de réalisation possible pour l'invention ;
- La Figure 3 est une représentation schématique en perspective de la platine de servitude de la Figure 2 ;
- La Figure 4 et la Figure 5 illustrent schématiquement en perspective des moyens de raccordement mécaniques entre différentes parties des platines de servitude des Figures 1 à 3.

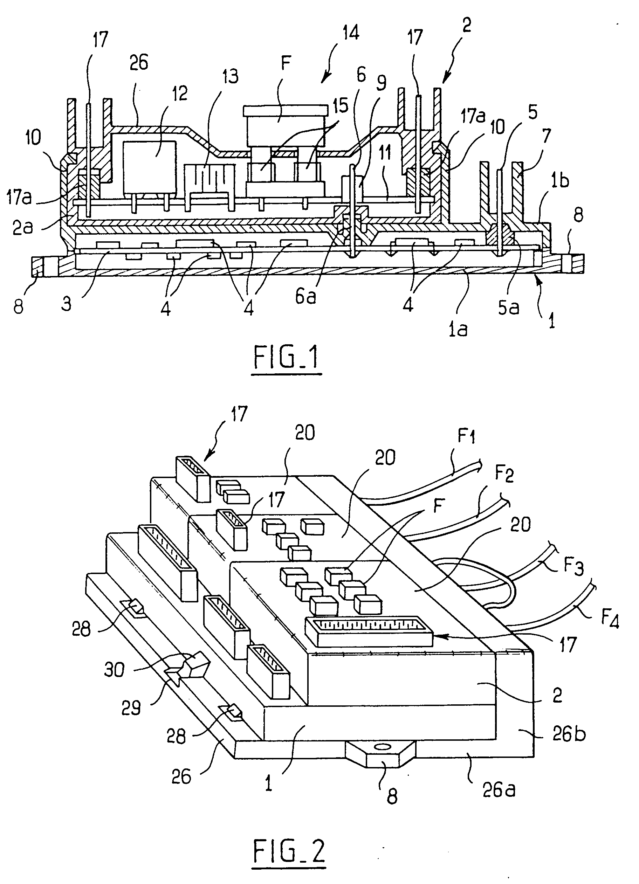

La platine de servitude représentée sur la Figure 1 comporte deux boîtiers 1 et 2 disposés l'un sur l'autre.

Le boîtier 1 est un boîtier plat dans lequel est reçu un circuit imprimé 3 portant une pluralité de composants électroniques 4 montés en surface, sur les deux faces du substrat de ce circuit 3.

Ce circuit imprimé 3 et les composants 4 qu'il porte regroupent l'ensemble de l'électronique de gestion des commandes.

Le substrat du circuit imprimé 3 porte également au moins deux rangées de broches ou languettes de connexion 5 et 6 maintenues par rapport audit substrat par des porte-broches 5a et 6a.

Les broches 5 sont destinées à assurer les connexions d'entrée et sortie de l'électronique du boîtier 1 avec différentes sources d'alimentation, ainsi qu'avec les organes de commande et les organes qui sont commandés par la platine de servitude.

Les rangées de broches 5 sont à cet effet disposées le long d'un des bords du boîtier plat 1. Elles s'étendent à l'extérieur dudit boîtier 1 dans des jupes de connectique 7 parallélépipédiques destinées à recevoir des moyens de connectique complémentaires reliés aux différents organes du véhicule.

Le boîtier 1 est constitué de deux demi-boîtiers 1a et 1b, par exemple en plastique moulé.

Le boîtier inférieur la présente à chacune de ses extrémités longitudinales une oreille 8 en saillie extérieure permettant la fixation de la platine de servitude sur un support à l'intérieur de l'habitacle du véhicule.

Le demi-boîtier supérieur lb est d'une pièce avec les jupes parallélépipédiques 7, ainsi qu'avec des branches élastiques 10 pour le positionnement, le détrompage et la fixation du boîtier 2 sur le boîtier 1.

Les broches de connexion 6 s'étendent à travers le demi-boîtier supérieur lb et sont destinées à coopérer avec des moyens de connectique femelles complémentaires 9 que présente le boîtier 2.

Le boîtier 2 comporte également un circuit imprimé de puissance 11, ainsi que différents composants que l'Homme du Métier désigne généralement sous la terminologie composants de puissance, tels que des relais 12, des résistances de shunt 13 ou des composants de protection 14.

Les composants de protection 14 représentés sur la Figure 1 comprennent des broches femelles porte-fusibles 15 positionnées sur une pièce support 16 elle-même montée sur le circuit intégré 11.

Ces broches 15 s'étendent à travers des évidements ménagés sur la paroi supérieure du boîtier 2 et coopèrent avec des moyens de connectique complémentaires que présentent des fusibles F rapportés sur ledit boîtier 2.

Le circuit imprimé de puissance 11 porte en outre des broches 17 qui s'étendent dudit circuit imprimé de puissance 11 jusqu'à l'extérieur et qui sont destinées à coopérer, de la même facon que les broches 5, avec des moyens de connectique complémentaires, reliés aux différentes sources d'alimentation en tension du véhicule, ainsi qu'aux organes ou charges à commander.

Ces broches 17 sont maintenues sur le circuit imprimé de puissance 11 par des porte-broches 17a.

Le boîtier 2 est constitué de deux demi-boîtiers 2a et 2b refermés l'un sur l'autre.

Le demi-boîtier supérieur 2b présente des moyens complémentaires de ceux portés par les pattes de fixation élastiques 10, qui assurent avec lesdites pattes 10 le maintien , le positionnement et le détrompage du boîtier 2 sur le boîtier 1.

Comme on l'aura compris, le regroupement des différentes électroniques dans le boîtier 1, ainsi que des organes de puissance dans le boîtier 2 permet une grande simplification de montage.

Le nombre de points de connexion est diminué, puisque la structure selon l'invention permet le regroupement des connexions à la masse, ainsi que le regroupement des différentes bornes d'alimentation et des différentes bornes pour la liaison aux différentes commandes ou organes.

Egalement, le nombre de composants pour la protection des électroniques est considérablement réduit, les composants de protection du boîtier 2 assurant de façon regroupée la protection des différents composants du boîtier 1.

On notera en outre qu'une telle platine de servitude est d'un montage simple.

On positionne et on fixe la carte qui correspond au circuit imprimé 3 et à ses différents composants 4 dans le demi-boîtier inférieur la. On referme le demi-boîtier supérieur lb sur le boîtier inférieur la en le positionnant de façon que les broches 5 soient convenablement reçues dans les jupes de connectique 7.

De la même façon, on positionne la carte qui correspond au circuit 11 et aux différents composants qu'il porte dans le demi-boîtier inférieur 2a sur lequel on referme le demi-boîtier supérieur 2b, puis on présente le boîtier 2 entre les pattes élastiques 10 du boîtier 1 jusqu'à ce que leurs moyens de fixation complémentaires soient en prise et assurent le maintien effectif du boîtier 2 sur le boîtier 1.

On peut ensuite fixer la platine de servitude ainsi réalisée sur un support à l'intérieur de l'habitacle du véhicule, au moyen des oreilles 8 du demi-boîtier inférieur la.

En variante, ainsi qu'on l'a illustré sur la Figure 2, la platine de servitude selon l'invention peut présenter plusieurs boîtiers de puissance 20 indépendants, qui, selon le niveau d'équipement du véhicule, sont ou non mis en place sur le boîtier 1.

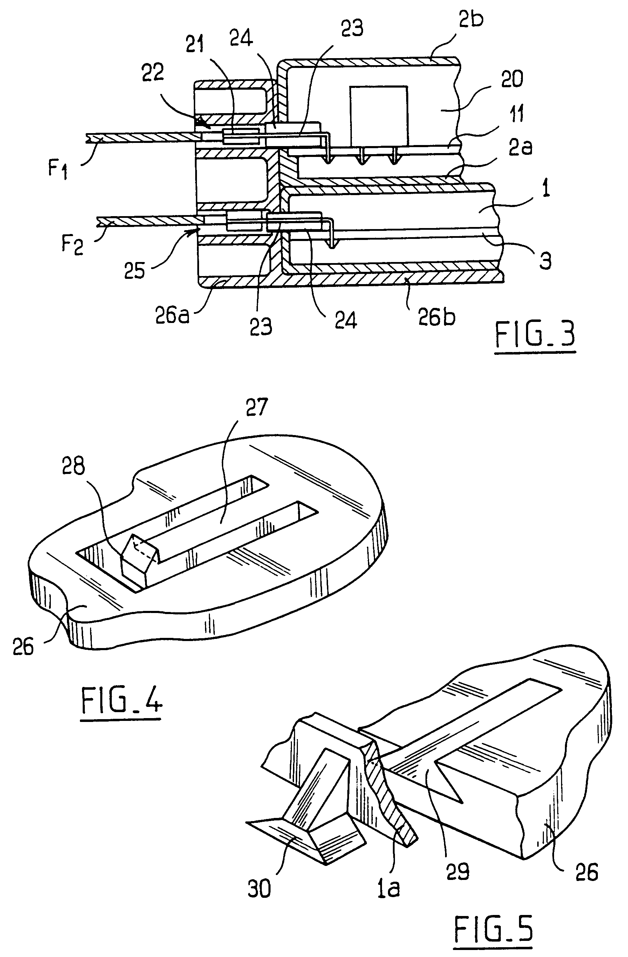

A cet effet, chacun des différents boîtiers de puissance 20 comporte des moyens de connectique pour assurer la liaison avec les sources d'alimentation qui lui sont necessaires (batterie, accessoires, après contact, etc). Sur les figures 2 et 3, ces liaisons ont été illustrées par les fils d'alimentation F1 à F4.

Avantageusement, ces boîtiers 20 et le boîtier 1, comportent alors des moyens de connexion 21 permettant un enfichage des moyens de connexion complémentaires 22 (figure 3) reliés aux différentes alimentations, par un mouvement de translation parallèle aux plans des boîtiers 1 et 20.

Les moyens de connexion 21 sont par exemple constitués par des broches 23 s'étendant en angle droit à partir des circuits intégrés 3 et 11 et traversant la tranche des boitiers 1 et 2.

Ces broches 23 sont maintenues par rapport aux circuits intégrés 3 et 11 par des porte-broches 24 qui traversent les tranches précitées des boîtiers 1 et 2.

Les moyens de connexion femelles 25 complémentaires sont maintenus dans un logement ménagé sur une branche 26a d'un support 26 en L, dont l'autre branche, référencée par 26b, est parallèle aux plans des boîtiers 1 et 20 et porte lesdits boîtiers. La branche 26b constitue la semelle du support 26, la branche 26a sa tranche.

Les moyens 27 à 30 pour le maintien mécanique du boîtier 1 sur le support 26 sont illustrés sur les Figures 4 et 5.

Ces moyens comprennent une patte élastique 27 qui est moulée d'une pièce avec la semelle 26b et qui se termine par un crochet 28 destiné à maintenir le boîtier 1 en appui contre la branche 26a du support (figure 4).

Ils comportent en outre une ou plusieurs rainure(s) par exemple en queue d'aronde 29 ménagée(s) dans l'épaisseur de la semelle du support, ainsi qu'un ou plusieurs téton(s) 30 complémentaire(s) qui est(sont) en saillie par rapport au fond dudit boîtier 1 et qui est(sont) issu(s) d'une seule pièce par moulage avec celui-ci (figure 5).

## Revendications

1. Platine de servitude de véhicule, notamment automobile, comportant des moyens d'électronique (12, 13, 14) de puissance portés au moins en partie par un substrat plan (3, 11) reçu dans un boîtier (2 ; 20), ce boîtier comportant des moyens (5, 17, 23) pour sa connexion électrique à des sources d'alimentation, ainsi qu'à des organes du véhicule commandés par lesdits moyens d'électronique, ladite platine comportant en outre des moyens d'électronique de gestion reçus dans un autre boîtier (1), les deux boîtiers (1, 2 ; 20) comportant des moyens de connexion mécaniques et électriques par lesquels ils sont assemblés de façon amovible, ladite platine étant caractérisée en ce qu'elle comporte plusieurs boîtiers d'électronique de puissance (20), les moyens de connexion du boîtier d'électronique de gestion (1) et des boîtiers d'électronique de puissance (20) permettant un assemblage modulable des boîtiers d'électronique de puissance (20) sur le boîtier d'électronique de gestion (1).

2. Platine de servitude selon la revendication 1, caractérisée en ce que chaque boîtier (1 ; 2, 20) comporte des moyens (5, 17, 23) pour sa connexion électrique à des sources d'alimentation, ainsi qu'à des organes du véhicule commandés par les moyens d'électronique portés par son substrat.

3. Platine de servitude selon les revendications 1 et 2, caractérisée en ce que lesdits moyens pour la connexion électrique des boîtiers (1, 2 ; 20) aux sources et aux organes du véhicule comportent d'une part des broches de connexion (5, 17) s'étendant à partir des substrats (3, 11) à l'intérieur des boîtiers et traversant les boîtiers (1, 2 ; 20) perpendiculairement aux plans desdits substrats (3, 11), ainsi que des broches de connexion (23) de forme en L s'étendant à partir desdits substrats et traversant la tranche des boîtiers (1, 2 ; 20).

4. Platine de servitude selon la revendication 3, caractérisée en ce que les boîtiers (1, 2 ; 20) sont portés par un support (26) comportant une partie semelle (26a), sur laquelle est fixé le boîtier d'électronique de gestion (1), et une tranche (26b) qui est perpendiculaire à ladite partie semelle (26a) et qui présente des moyens de connexion femelles (25) destinées à coopérer avec les broches en L (23) des boîtiers.

5. Platine de servitude selon la revendication 4, caractérisée en ce que les moyens pour la fixation du boîtier d'électronique de gestion sur la partie semelle du support comporte un téton (30) reçue dans une rainure complémentaire (29), ainsi que des moyens de verrouillage élastique (27, 28).

6. Platine de servitude selon l'une des revendications précédentes, caractérisée en ce que le boîtier d'électronique de gestion présente des pattes de verrouillage élastiques (10) pour l'assemblage du ou des boîtiers d'électronique de puissance sur ledit boîtier d'électronique de gestion.

7. Platine de servitude selon l'une des revendications précédentes, caractérisée en ce qu'un boîtier (1, 2 ; 20) est constitué par deux demi-boîtiers en plastique moulé assemblés l'un sur l'autre.

8. Platine de servitude selon l'une des revendications précédentes, caractérisée en ce que le boîtier d'électronique de gestion présente deux oreilles (8) latérales opposées pour la fixation de la platine de servitude à l'intérieur de l'habitacle du véhicule.

9. Platine de servitude selon l'une des revendications 4 et 5, caractérisée en ce que la partie semelle (26a) du support (26) présente deux oreilles (8) latérales opposées pour la fixation de la platine de servitude à l'intérieur de l'habitacle du véhicule.

## Claims

1. Equipment panel for a vehicle, notably a motor car, including power electronics means (12, 13, 14) carried at least partly by a flat substrate (3, 11) received in a housing (2; 20), this housing having means (5, 17, 23) for its electrical connection to power sources, and to components of the vehicle controlled by the said electronic means, the said panel also including management electronics means received in another housing (1), the two housings (1, 2; 20) having mechanical and electrical connection means by which they are removably connected, the said panel being characterised in that it has several power electronics housings (20), the means of connecting the management electronics housing (1) and the power electronics housings (20) allowing a modular connection of the power electronics housings (20) to the management electronics housing (1).

2. Equipment panel according to Claim 1, characterised in that each housing (1; 2, 20) has means (5, 17, 23) for its electrical connection to power sources, as well as to components of the vehicle controlled by the electronic means carried by its substrate.

3. Equipment panel according to Claims 1 and 2, characterised in that the said means for the electrical connection of the housings (1, 2; 20) to the sources and to the vehicle components have on the one hand connection pins (5, 17) extending from the substrates (3, 11) inside the housing for passing through the housings (1, 2; 20) perpendicularly to the planes of the said substrates (3, 11), as well as L-shaped connecting pins (23) extending from the said substrates and passing through the edge of the housings (1, 2; 20).

4. Equipment panel according to Claim 3, characterised in that the housings (1, 2; 20) carried by a support (25) having a base-plate part (26a), to which the management electronics housing (1) is fixed, and an edge (26b) which is perpendicular to the said base-plate part (26a) and which has female connection means (35) intended to cooperate with the L-shaped pins (23) of the housings.

5. Equipment panel according to Claim 4, characterised in that the means for fixing the management electronics housing to the base-plate part of the support has a stud (30) received in a complementary groove (29), as well as elastic locking means (27, 28).

6. Equipment panel according to one of the preceding claims, characterised in that the management electronics housing has elastic locking lugs (10) for connecting the power electronics housing or housings to the said management electronics housing.

7. Equipment panel according to one of the preceding claims, characterised in that a housing (1, 2; 20) consists of two half-housings made of moulded plastic connected to each other.

8. Equipment panel according to one of the preceding claims, characterised in that the management electronics housing has two opposing side brackets (8) for fixing the equipment panel to the inside of the vehicle passenger compartment.

9. Equipment panel according to one of Claims 4 and 5, characterised in that the base-plate part (26a) of the support (26) has two opposed side brackets (8) for fixing the equipment panel to the inside of the vehicle passenger compartment.

## Patentansprüche

1. Zentralelektrik für Fahrzeuge, insbesondere für Kraftfahrzeuge, umfassend Leistungselektronikmittel (12, 13, 14), die wenigstens teilweise auf einem in einem Gehäuse (2; 20) aufgenommenen ebenen Substrat (3, 11) angebracht sind, wobei dieses Gehäuse Mittel (5, 17, 23) für seinen elektrischen Anschluß an Stromversorgungsquellen sowie an Organe des Fahrzeugs umfaßt, die durch die besagten Elektronikmittel gesteuert werden, wobei die besagte Zentralelektrik außerdem Steuerungselektronikmittel umfaßt, die in einem anderen Gehäuse (1) aufgenommen sind, wobei die beiden Gehäuse (1, 2; 20) mechanische und elektrische Anschlußmittel umfassen, durch die sie abnehmbar verbunden sind, wobei die besagte Zentralelektrik **dadurch gekennzeichnet** ist, daß sie mehrere Leistungselektronikgehäuse (20) umfaßt, wobei die Anschlußmittel des Steuerungselektronikgehäuses (1) und der Leistungselektronikgehäuse (20) eine modulierbare Anfügung der Leistungselektronikgehäuse (20) am Steuerungselektronikgehäuse (1) ermöglichen.

2. Zentralelektrik nach Anspruch 1 , **dadurch gekennzeichnet,** daß jedes Gehäuse (1; 2, 20) Mittel (5, 17, 23) für seinen elektrischen Anschluß an Stromversorgungsquellen sowie an Organe des Fahrzeugs umfaßt, die durch die auf seinem Substrat angebrachten Elektronikmittel gesteuert werden.

3. Zentralelektrik nach einem der Ansprüche 1 und 2, **dadurch gekennzeichnet,** daß die besagten Mittel für den elektrischen Anschluß der Gehäuse (1, 2; 20) an die Stromversorgungsquellen und an die Organe des Fahrzeugs einerseits Anschlußstifte (5, 17), die sich von den Substraten (3, 11) im Innern der Gehäuse aus erstrecken und durch die Gehäuse (1, 2; 20) senkrecht zu den Ebenen der besagten Substrate (3, 11) hindurchgehen, sowie L-förmige Anschlußstifte (23) umfassen, die sich von den besagten Substraten aus erstrecken und durch den Randteil der Gehäuse (1, 2; 20) hindurchgehen.

4. Zentralelektrik nach Anspruch 3 , **dadurch gekennzeichnet,** daß die Gehäuse (1, 2; 20) auf einem Träger (26) angebracht sind, der einen Fußteil (26a), auf dem das Steuerungselektronikgehäuse (1) befestigt ist, und einen Randteil (26b) umfaßt, der senkrecht zu dem besagten Fußteil (26a) angeordnet ist und der Buchsenanschlußmittel (25) aufweist, die dazu bestimmt sind, mit den L-förmigen Stiften (23) der Gehäuse zusammenzuwirken.

5. Zentralelektrik nach Anspruch 4 , **dadurch gekennzeichnet,** daß die Mittel zur Befestigung des Steuerungselektronikgehäuses auf dem Fußteil des Trägers einen Zapfen (30), der in eine formschlüssige Nut (29) eingesetzt ist, sowie Mittel zur elastischen Verriegelung (27, 28) umfassen.

6. Zentralelektrik nach einem der vorangehenden Ansprüche, **dadurch gekennzeichnet**, daß das Steuerungselektronikgehäuse elastische Verriegelungsansätze (10) für die Anfügung des oder der Leistungselektronikgehäuse an das besagte Steuerungselektronikgehäuse aufweist.

7. Zentralelektrik nach einem der vorangehenden Ansprüche, **dadurch gekennzeichnet**, daß ein Gehäuse (1, 2; 20) aus zwei aneinandergefügten Gehäusehälften aus Kunststoff-Formteilen besteht.

8. Zentralelektrik nach einem der vorangehenden Ansprüche, **dadurch gekennzeichnet**, daß das Steuerungselektronikgehäuse zwei gegenüberliegende seitliche Nasen (8) für die Befestigung der Zentralelektrik im Innern des Fahrgastraums des Fahrzeugs aufweist.

9. Zentralelektrik nach einem der Ansprüche 4 und 5, **dadurch gekennzeichnet**, daß der Fußteil (26a) des Trägers (26) zwei gegenüberliegende Nasen (8) für die Befestigung der Zentralelektrik im Innern des Fahrgastraums des Fahrzeugs aufweist.
